# EUROPÄISCHE PATENTSCHRIFT

(11) **EP 2 190 082 B1**
(45) Veröffentlichungstag und Bekanntmachung des Hinweises auf die Patenterteilung: **09.01.2013**
(21) Anmeldenummer: 09175845.8
(22) Anmeldetag: 12.11.2009
(51) Int. Cl.: H01S 5/183

(54) **Oberflächenemittierende Halbleiterlaserdiode und Verfahren zur Herstellung derselben**
Surface emitting semi-conductor laser diode and method for manufacturing the same
Diode laser semi-conductrice émettant en surface et son procédé de fabrication

(30) Priorität: 21.11.2008 DE 102008058402; 12.03.2009 DE 102009001505
(43) Veröffentlichungstag der Anmeldung: 26.05.2010
(73) Patentinhaber: Vertilas GmbH, 85748 Garching (DE)
(72) Erfinder: Amann, Markus-Christian, 80935, München (DE); Ortsiefer, Markus, 80939 München (DE)
(74) Vertreter: Kudlek & Grunert Patentanwälte

(56) Entgegenhaltungen:
- EP-A2- 0 798 574
- GB-A- 2 428 887
- JP-A- 2005 039 102
- US-A1- 2007 242 715
- STEPHEN Y. CHOUA AND WENYONG DENG: "Subwavelength amorphous silicon transmission gratings and applications in polarizers and waveplates", APPLIED PHYSICS LETTERS, AIP, Bd. 67, Nr. 6, 7. August 1995 (1995-08-07) , Seiten 742-744, XP012014514, AMERICAN INSTITUTE OF PHYSICS, MELVILLE, NY, US ISSN: 0003-6951, DOI: 10.1063/1.115211
- LU D ET AL: "All-epitaxial current- and mode-confined AlGaAs/GaAs VCSEL", ELECTRONICS LETTERS, Bd. 40, Nr. 21, 14. Oktober 2004 (2004-10-14), Seiten 1336-1337, XP006022754, IEE STEVENAGE, GB ISSN: 0013-5194, DOI: 10.1049/EL:20046159
- M C Riedl et al: "Approaches for Polarization Control in VCSELs", Jahresbericht universitàt Ulm , 2000, Seiten 21-26, XP002623387, Gefunden im Internet: URL:http://www.uni-ulm.de/fileadmin/websit e_uni_ulm/iui.inst.140/Jahresbericht/2000/ ar2000_mir.pdf [gefunden am 2011-02-17]

## Beschreibung

Die vorliegende Erfindung betrifft eine oberflächenemittierende Halbleiterlaserdiode nach dem Oberbegriff des Patentanspruchs 1 und ein Verfahren zur Herstellung einer solchen oberflächenemittierenden Halbleiterlaserdiode.

### Stand der Technik

Oberflächenemittierende Laserdioden (engl.: Vertical-Cavity Surface-Emitting Laser - VCSEL) stellen Halbleiterlaser dar, bei denen die Lichtemission senkrecht zur Oberfläche des Halbleiterchips stattfindet. Verglichen mit konventionellen, kantenemittierenden Laserdioden weisen die oberflächenemittierenden Laserdioden mehrere Vorteile auf, wie einen geringen elektrischen Leistungsverbrauch, die Möglichkeit der unmittelbaren Überprüfung der Laserdiode auf dem Wafer, einfache Ankopplungsmöglichkeiten an eine Glasfaser, longitudinale Einmodenspektren und die Möglichkeit der Zusammenschaltung der oberflächenemittierenden Laserdioden zu einer zweidimensionalen Matrix.

Gattungsgemäße oberflächenemittierende Halbleiterlaserdioden mit einer Emissionswellenlänge λ (=Vakuumwellenlänge) weisen einen Resonator auf, der zumindest eine erste Bragg-Reflektorschichtenfolge (engl.: Distributed Bragg Reflector - DBR), eine einen pn-Übergang aufweisende aktive Zone und eine zweite Bragg-Reflektorschichtenfolge umfasst. Derartige Laserdioden besitzen in der Regel eine zylindersymmetrische Struktur und weisen aufgrund ihres Designs sowie ihrer Herstellungsverfahren keine Vorzugsrichtung für die Polarisationsrichtung der abgestrahlten Welle auf. Es existieren daher zwei orthogonale Zustände bzgl. der Polarisationsrichtung der abgestrahlten Welle. In einer idealen Laserstruktur sind diese beiden Zustände energetisch entartet und für den Laserbetrieb gleichberechtigt. Aufgrund des elektrooptischen Effektes und von Anisotropien im Bauelementedesign sowie Asymmetrien und Fluktuationen des Herstellungsprozesses wird diese Entartung jedoch aufgehoben und der VCSEL schwingt dominant nur auf der jeweils bevorzugten Polarisationsmode. In den meisten Fällen ist der zur Bevorzugung einer bestimmten Mode führende Mechanismus schwer kontrollierbar bzw. nicht offensichtlich, womit sich insgesamt ein statistischer Charakter des Polarisationsverhaltens ergibt. Die Polarisationssprünge limitieren generell den Einsatz in polarisationsabhängigen optischen Systemen. Beispielsweise führen solche Sprünge in der optischen Datenübertragung zu einem erhöhten Rauschen. Da viele Anwendungen auf polarisationsstabile Laser als Lichtquellen angewiesen sind, bedeutet dies eine signifikante Reduktion der Produktionsausbeute. In manchen Fällen ist zwar eine Vorzugsrichtung definierbar, doch ist die Aufhebung der Entartung nicht stark genug, um Polarisationsstabilität bei veränderlichen Umgebungs- und Betriebsbedingungen zu gewährleisten. In diesem Fall können selbst leichte Veränderungen dieser Parameter einen Wechsel zwischen den beiden Zuständen (Polflip) bewirken.

In der Vergangenheit wurden verschiedene Möglichkeiten zur Stabilisierung der Polarisation studiert. Zur Erreichung von Polarisationsstabilität von GaAs-basierten VCSEL wurde das Wachstum auf höher indizierten [311]-Substraten erfolgreich nachgewiesen, vgl. hierzu "An 850-nm InAlGaAs Strained Quantum-Well Vertical-Cavity Surface-Emitting Laser Grown on GaAs (311)B Substrate with High-Polarization Stability", IEEE Photon. Technol. Lett., 12, 942 (2000). Da sich jedoch die sonstigen Lasereigenschaften in der Regel verschlechtern und insbesondere für InP-basierte Halbleiterschichten schwierige Wachstumsbedingungen bestehen, erscheint diese Methode für langwellige VCSEL nicht geeignet.

Ein anderer Ansatz beinhaltet das Aufbringen von dielektrischen oder metallischen Gitterstrukturen mit Perioden im Wellenlängenbereich auf den Auskoppel-Spiegel. Dies wird bspw. in der Veröffentlichung "Polarisation stabilisation of vertical-cavity top-surface-emitting lasers by inscription of fine metal-interlaced gratings", Appl. Phys. Lett. 66, 2769 (1995) oder der DE 103 53 951 A1 beschrieben. Die verwendeten dielektrischen Gitter führen zu Interferenzeffekten, wodurch die Gesamtreflexion polarisationsabhängig durch das Gitter verstärkt oder abgeschwächt wird. Die Periode der entsprechenden Gitterstrukturen muss daher mehr als eine halbe Vakuumwellenlänge betragen.

Daneben ist auch bekannt, Metall/Dielektrikum- oder Metall/Halbleiter-Strukturen mit Perioden kleiner als die Wellenlänge des VCSEL auf eine der beiden Bragg-Reflektorschichtenfolgen aufzubringen, um eine Polarisation durch Doppelbrechung zu erzeugen. Dies wird bspw. in der Veröffentlichung "Polarization control of vertical-cavity surface-emitting lasers using a birefringent metal/dielectric polarizer loaded on top distributed Bragg Reflector", IEEE J. Sel. Top. Quantum. Electron. 1, 667 (1995) oder der JP 80 56 049 (A) offenbart. Bei dieser Lösung sollen metallisch-dielektrische Gitter zur Erzeugung von Doppelbrechung im Laserresonator dienen. Damit soll die optische Resonatorlänge bzw. die Resonanzfrequenz des Laserresonators nur bei einer Polarisation mit dem Reflektivitätsmaximum des bzw. der Braggspiegel übereinstimmen. Die andere Polarisation soll unterdrückt werden. Die beschriebenen experimentellen Ergebnisse zeigen jedoch, dass die erzielbare Polarisationsausrichtung nicht ausreichend ist.

Während die oben beschriebenen Ausführungsformen eine periodische Struktur zur Polarisationskontrolle außerhalb des inneren Resonatorbereiches (letzterer entspricht dem Bereich zwischen den beiden Braggreflektorschichten), aufweisen, beschreibt JP 2005 039102 A einen Aufbau, bei der sich das periodische Gitter zwischen den beiden Braggreflektorfolgen befindet. Diese Struktur besteht andererseits aus zwei getrennten und unabhängigen Komponenten, wobei sich das periodische Gitter nicht in unmittelbarem Kontakt mit einer der beiden Braggreflektorschichtfolgen befindet. Probleme, die bei der Herstellung einstückiger bzw. monolithischer Dioden typisch sind, wie z.B. Diffusion, treten daher bei dieser Ausgestaltung nicht auf.

Eine weitere Ausführungsform eines periodischen Gitters wird in US 2003/0048827 A1 beschrieben. Hierbei wird ein monolithischer Aufbau verwendet, bei der das Gitter epitaktisch in eine der beiden Halbleiter-Braggreflektorschichtfolgen integriert ist. Das Wechselschichtsystem basiert hierbei in erster Linie auf einer unterschiedlichen Dotierung. Hiermit können jedoch nur vergleichsweise kleine Brechzahldifferenzen erzeugt werden, wodurch sich keine ausreichende Polarisationsmodenaufspaltung ergibt.

Einen anderen Ansatz zur Polarisationsstabilisierung verfolgt die GB 2 428 887 A. Bei einer gattungsgemäßen Halbleiterdiode werden photonische Kristalle zur Polarisationsstabilisierung verwendet. Photonische Kristalle unterscheiden sich jedoch wesentlich von Subwellenlängengittern, so dass als Folge auch die erreichbare Polarisationsstabilität nicht optimal ist.

Ausgehend von diesem Stand der Technik stellt sich somit die Aufgabe, die Polarisationsausrichtung und Polarisationsstabilität in oberflächenemittierenden Halbleiterlaserdioden zu verbessern.

Zur Lösung dieser Aufgabe werden eine oberflächenemittierende Halbleiterlaserdiode und ein Verfahren zu deren Herstellung mit den Merkmalen der unabhängigen Patentansprüche vorgeschlagen. Vorteilhafte Ausgestaltungen sind Gegenstand der Unteransprüche sowie der nachfolgenden Beschreibung.

### Vorteile der Erfindung

Die vorliegende Erfindung präsentiert einen polarisationsstabilen VCSEL. Die Erfindung beinhaltet dabei insbesondere die Integration einer periodischen Struktur mit definierter Orientierung, Geometrie und einem definierten Brechzahlprofil innerhalb des monolithischen VCSEL-Resonators in Form eines Subwellenlängengitters (engl. Subwavelength grating: SWG). Die Struktur ermöglicht ein deterministisches und stabiles Polarisationsverhalten bei hoher Polarisationsmoden-Seitenmodenunterdrückung sowie Unempfindlichkeit gegenüber Rückkopplung. Zudem bevorzugt die erfindungsgemäße Laserdiode den lateralen Grundmodus auch bei größeren Aperturen, wodurch sich insgesamt höhere Einmodenleistungen als bei herkömmlichen VCSELn erreichen lassen.

Bei den bekannten Lösungen, die ein Gitter bzw. eine periodische Struktur zur Polarisation verwenden, wird die Gitterstruktur außen auf dem Auskoppelspiegel angebracht, wodurch die zu erreichende Qualität der Reflexions- und Polarisationseigenschaften begrenzt wird.

Erfindungsgemäß wurde erkannt, dass eine periodische Struktur aus halbleitendem Material einerseits und dielektrischem Material andererseits geeignet ist, innerhalb des Resonators angeordnet zu werden. Die Struktur weist einen genügend großen Brechzahlkontrast auf, um mittels Doppelbrechung eine bevorzugte Polarisationsrichtung vorzugeben.

Vorteilhafterweise beträgt die Periode der periodischen Struktur höchstens eine, vorzugsweise höchstens eine halbe Emissionswellenlänge. Somit können Interferenzeffekte unterdrückt werden, welche bei der vorliegenden Anwendung nicht erwünscht sind. In dieser Anmeldung wird unter dem Begriff "Emissionswellenlänge" immer die Vakuumwellenlänge verstanden.

In Ausgestaltung beträgt die Periode der Struktur höchstens λ/n, vorzugsweise höchstens λ/2n, wobei n eine Funktion der Brechzahl des halbleitenden Materials und/oder der Brechzahl des dieelektrischen Materials ist. Beispielsweise entspricht n einer sog. effektiven Brechzahl, die sich insbesondere als, vorzugsweise arithmetisch gewichteter, Mittelwert der beiden Brechzahlen berechnet. Ebenso ist bevorzugt, wenn n der größeren der beiden Brechzahlen entspricht. Bei einer derartigen Ausgestaltung ist die polarisationsabhängige Mittelung der Brechzahl besonders ausgeprägt. Bei einer Emissionswellenlänge von 1310 nm und einer (größeren) Brechzahl von z.B. n=3,2 für InP als Halbleiter ergibt dies eine Periodenlänge von höchstens ∼400 nm. Im Falle einer beugungsgitterartigen Struktur (d.h. ein Gitter aus regelmäßig beabstandeten Längsstrukturen) kann das Tastverhältnis (Verhältnis von Steg- und Grubenbreite) 1:1 betragen oder davon abweichende Werte besitzen. Bei dem obigen Beispiel könnten die Steg- und Grubenbreiten jeweils 200 nm betragen. Es wird erwartet, dass die Polarisationsstabilität umso besser ist, je kleiner die Periodenlänge ist.

Im Gegensatz zu den im Stand der Technik beschriebenen Gitterstrukturen werden somit vorzugsweise deutlich kleinere Perioden im Subwellenlängenbereich verwendet (typischerweise kleiner als die halbe Emissionswellenlänge), da es auf die Erzeugung einer polarisationsabhängigen effektiven Brechzahl ankommt und nicht auf die polarisationsabhängige Erhöhung der Spiegelreflektivität mit größerperiodischen Gittern.

Gemäß einer bevorzugten Ausgestaltung grenzt die periodische Struktur unmittelbar an die zweite Bragg-Reflektorschichtenfolge. Die vorliegende Ausgestaltung lehrt somit insbesondere, eine effektive Doppelbrechung durch Anordnung einer Halbleiter/Dielektrikum-Struktur innerhalb des Resonators zu erzeugen, wobei die Struktur vor einem metallischen, dielektrischen oder hybriden metallisch-dielektrischen Spiegel platziert wird.

Vorzugsweise ist das dielektrische Material der periodischen Struktur gleich dem Material der angrenzenden Schicht der zweiten Bragg-Reflektorschichtenfolge. Auf diese Weise ist eine einfache Herstellung möglich, wobei vorzugsweise auf einer Halbleiterschicht, welche den halbleitenden Bestandteil der periodischen Struktur umfassen soll, zunächst eine Maske definiert wird. Dies erfolgt durch einschlägige Nanostrukturtechniken wie Elektronenstrahllithografie, Nanoimprint, Holographie usw. Anschließend wird, bspw. durch eine trockenchemische Ätzung, die zuvor definierte Struktur in den Halbleiter übertragen. Die Ätztiefe wird dabei so gewählt, dass sich eine stabile Vorzugsrichtung der Polarisation ergibt. Die Ätztiefe beträgt für einen langwelligen InP-basierten VCSEL z.B. ∼200 nm. Die Ätztiefe kann insbesondere zwischen 0,1 und 2, vorzugsweise zwischen 0,5 und 1, vorzugsweise ca. 0,5 Periodenlängen betragen. Nach Entfernung der Lackmaske wird die freiliegende Struktur mit einem dielektrischen Material bedampft, das unmittelbar in eine Braggspiegel-Schichtenfolge, z.B. aus ZnS/CaF₂ oder a-Si/CaF₂, übergeht. Im Unterschied zu einem konventionellen VCSEL ohne Gitter sollte sowohl die Dicke der halbleitenden Schicht als auch die Dicke der ersten dielektrischen Spiegelschicht so modifiziert werden, dass eine maximale Polarisationsstabilität erzielt wird. Dazu sollte die Reflexion innerhalb des Braggspiegels in Phase zur Reflexion an der Grenzfläche zwischen Struktur und Braggspiegel sein.

Zweckmäßigerweise umfasst die zweite Bragg-Reflektorschichtenfolge eine Anzahl von amorphen dielektrischen Schichten. Dadurch kann die Herstellung vereinfacht werden. Zur Erhöhung der Reflektivität kann noch eine abschließende Schicht, bspw. aus Gold, aufgebracht werden. Bei der zweiten Bragg-Reflektorschichtenfolge handelt es sich üblicherweise um den rückwärtigen Spiegel des VCSELs. Der Auskoppelspiegel des VCSEL wird bei der Herstellung üblicherweise als epitaktische Schichtenfolge direkt auf das Substrat aufgebracht.

Gemäß einer bevorzugten Ausgestaltung weist der Resonator weiterhin eine Tunnelkontaktschicht auf der p-Seite der aktiven Zone auf. Die mit Abstand besten Resultate für langwellige VCSELs im Wellenlängenbereich oberhalb 1,3 µm hinsichtlich Leistung, Betriebstemperatur, Einmodenleistung sowie Modulationsbandbreite weisen, insbesondere InP-basierte, BTJ-VCSEL auf (engl.: Buried Tunnel Junction, BTJ), da durch Verwendung eines BTJ u.a. der Stromfluss auf den eigentlichen Bereich der aktiven Zone beschränkt werden kann. Zweckmäßigerweise ist zwischen aktiver Zone und BTJ eine p-Confinementschicht angeordnet. Ebenso zweckmäßig ist auf der vom BTJ abgewandten Seite (n-Seite) der aktiven Zone eine n-Confinementschicht angeordnet. Diese Confinement-Schichten sollen für die im Betrieb injizierten Ladungsträger Barrieren bilden, um die Aufenthaltsdauer der Ladungsträger in der aktiven Zone zu erhöhen.

Zweckmäßigerweise entspricht eine Abmessung, bspw. eine Länge oder ein Durchmesser, oder die Fläche der Projektion der periodischen Struktur auf die Tunnelkontaktschicht zumindest einer Abmessung bzw. der Fläche einer Apertur der Tunnelkontaktschicht. Die Erzeugung der Laserstrahlung findet im wesentlichen in der von der Apertur der Tunnelkontaktschicht horizontal definierten Fläche statt. Um eine gute Polarisationsstabilität zu erhalten, sollte sich die periodische Struktur zumindest auf diese Fläche erstrecken.

Es ist von Vorteil, wenn die Tunnelkontaktschicht an eine n-dotierte Halbleiterschicht grenzt. Diese Halbleiterschicht kann zur Stromzuführung und Kontaktierung des BTJ dienen. Gleichzeitig kann diese Halbleiterschicht an das halbleitende Material für die periodische Struktur grenzen oder dieses umfassen, so dass die Halbleiterschicht unmittelbar in die periodische Struktur übergeht. An dieser Stelle sei auch auf die obigen Ausführungen zu einer Dickenanpassung der Halbleiterschicht verwiesen.

Erfindungsgemäß wird ein Resonator umfassend zumindest eine erste Bragg-Reflektorschichtenfolge, eine einen pn-Übergang aufweisende aktive Zone und eine zweite Bragg-Reflektorschichtenfolge auf ein Substrat aufgebracht. Es wird weiterhin eine periodische Struktur aus halbleitendem Material einerseits und dielektrischem Material andererseits innerhalb des Resonators aufgebracht, deren Haupterstreckungsebene im wesentlichen senkrecht zur Abstrahlrichtung angeordnet ist. Mit dem erfindungsgemäßen Verfahren lässt sich eine erfindungsgemäße Laserdiode besonders zuverlässig bzw. reproduzierbar und mit hoher Qualität herstellen.

In bevorzugter Ausgestaltung wird zunächst die als n-dotierter epitaktischer Bragg-Spiegel ausgebildete erste Bragg-Reflektorschichtenfolge, anschließend eine n-dotierte Confinementschicht, anschließend die einen pn-Übergang aufweisende aktive Zone, anschließend eine p-dotierte Confinementschicht und anschließend eine Tunnelkontaktschicht aufgebracht. Danach wird die Tunnelkontaktschicht strukturiert, um eine Apertur zu erzeugen. Daraufhin wird eine Halbleiterschicht aufgebracht, die strukturiert wird, um die periodische Struktur zu definieren. Anschließend wird die zweite Bragg-Reflektorschichtenfolge aufgebracht. Dieses bevorzugte Herstellungsverfahren führt zu qualitativ hochwertigen Laserdioden mit guter Strahlleistung und Polarisationsstabilität.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand eines Ausführungsbeispiels in der Zeichnung schematisch dargestellt und wird im folgenden unter Bezugnahme auf die Zeichnung ausführlich beschrieben.

### Figurenbeschreibung

- Figur 1: zeigt schematisch den Schichtaufbau einer ersten bevorzugten Ausführungsform einer erfindungsgemäßen Laserdiode.
- Figur 2: zeigt schematisch den Schichtaufbau einer zweiten bevorzugten Ausführungsform einer erfindungsgemäßen Laserdiode.
- Figur 3: zeigt die zeitliche Abfolge der einzelnen Schritte zur Herstellung einer für die Erfindung geeigneten periodischen Struktur.
- Figur 4: zeigt die periodische Struktur gemäß Figur 3 schematisch von oben.

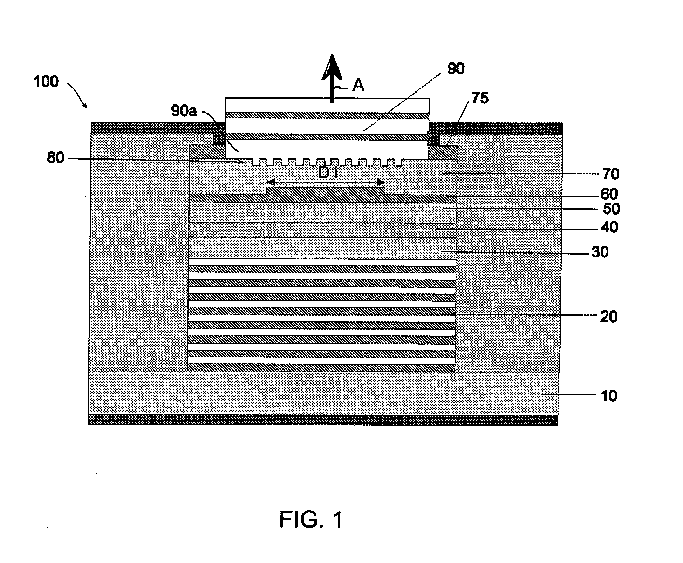

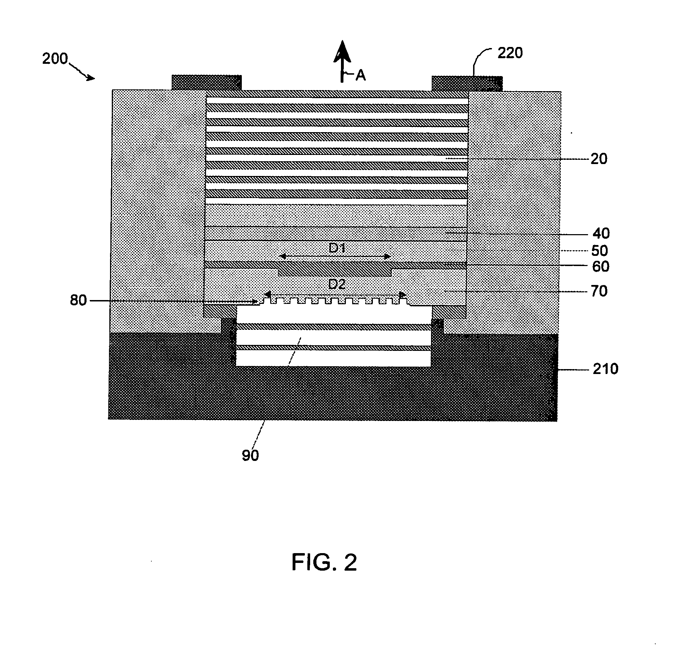

Nachfolgend werden zunächst die Figuren 1 und 2 figurenübergreifend beschrieben, wobei gleiche Elemente mit gleichen Bezugszeichen versehen sind.

In den Figuren 1 und 2 ist eine erste bzw. zweite bevorzugte Ausführungsform einer erfindungsgemäßen Laserdiode in einer Schnittansicht schematisch dargestellt und insgesamt mit 100 bzw. 200 bezeichnet. Die Laserstrahlung tritt in beiden Figuren 1 und 2 in die mit A bezeichnete Richtung aus.

Im folgenden wird insbesondere der Aufbau des Resonators, welcher durch zwei Bragg-Spiegel 20 und 90 begrenzt wird, näher erläutert.

Ausgehend von einem InP-Substrat 10 werden in einem ersten epitaktischen Wachstumsprozess nacheinander eine hier als n-dotierter epitaktischer Bragg-Spiegel 20 ausgebildete erste Bragg-Reflektorschichtenfolge, eine n-dotierte Confinementschicht 30, eine aktive Zone 40 sowie eine p-dotierte Confinementschicht 50 aufgebracht. Der Bragg-Spiegel 20 besteht aus einem epitaktischen DBR mit einer Reflektivität > 99%. % ergibt. Die Struktur wird abgeschlossen durch das Wachstum einer Tunnelkontaktschicht 60, bestehend z.B. aus jeweils einer hoch p⁺- und n⁺-dotierten InGaAs-Schicht, welche sich in einem Knoten (Minimum) des longitudinalen Feldes befindet. Im nachfolgenden Lithographie- und Ätzprozess wird eine freidimensionierbare Apertur D1 in der Schicht 60 erzeugt, die entweder bis zur Schicht 50 reicht oder innerhalb des p-dotierten Teils von Schicht 60 endet. Typische Ätztiefen liegen hier bei 20 nm.

In einem zweiten Epitaxieschritt wird eine obere n-dotierte Stromzuführungsschicht 70, bestehend vorzugsweise aus InP, und eine optionale n-Kontaktschicht 75, bestehend vorzugsweise aus hoch n-dotiertem InGaAs, aufgebracht. Anschließend wird eine periodische Struktur 80 erzeugt. Dazu wird auf der freiliegenden Halbleiterschicht 70 eine Maske definiert, wofür bspw. Nanostrukturtechniken wie Elektronenstrahllithografie, Nanoimprint oder Holographie geeignet sind. Anschließend wird, bspw. durch eine trockenchemische Ätzung die zuvor definierte Struktur in die Halbleiterschicht 70 übertragen. Die Ätztiefe beträgt für einen langwelligen InP-basierten VCSEL z.B. ∼200 nm. Nach Entfernung der Lackmaske wird das freiliegende Gitter anschließend mit einer hier als dielektrischen Braggspiegel 90 ausgebildeten zweiten Bragg-Reflektorschichtenfolge z.B. aus ZnS/CaF₂ oder a-Si/CaF₂ bedampft. Die periodische Struktur 80 setzt sich somit aus Anteilen der Halbleiterschicht 70 und Anteilen der ersten bzw. angrenzenden dielektrischen Schicht 90a zusammen. Die Haupterstreckungsebene der Struktur 80 ist im wesentlichen senkrecht zur Abstrahlrichtung A der Halbleiterlaserdiode 100 angeordnet.

Die in Figur 2 dargestellte, zweite bevorzugte Ausführungsform 200 unterscheidet sich von der Laserdiode 100 insofern, als eine Umkehrung der Schichtenfolge vorliegt. Nach Aufbringung der zweiten Bragg-Reflektorschichtenfolge 90 wird diese von einer Goldschicht 210 abgeschlossen, wodurch sich eine Reflektivität von nahezu 99,9 % ergibt. Anschließend wird das Substrat (Substrat 10 gem. Figur 1), bspw. durch bekannte Ätztechniken, entfernt. Zur Kontaktierung der Laserdiode 200 wird eine, bspw. ringförmige, Kontaktschicht 220 aufgebracht. D1 bezeichnet eine Abmessung (Apertur) der Tunnelkontaktschicht 60, D2 eine Abmessung der periodischen Struktur 80.

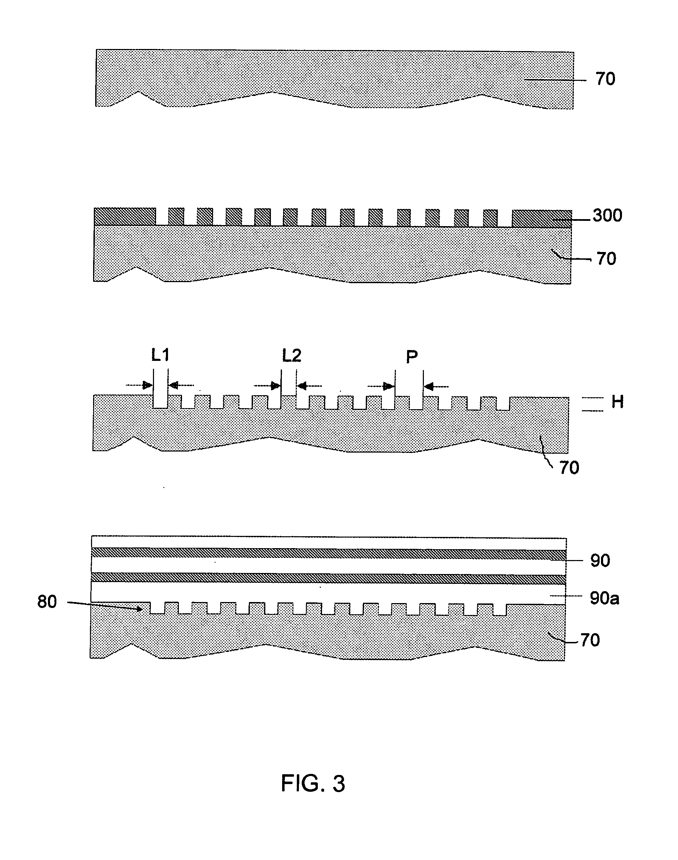

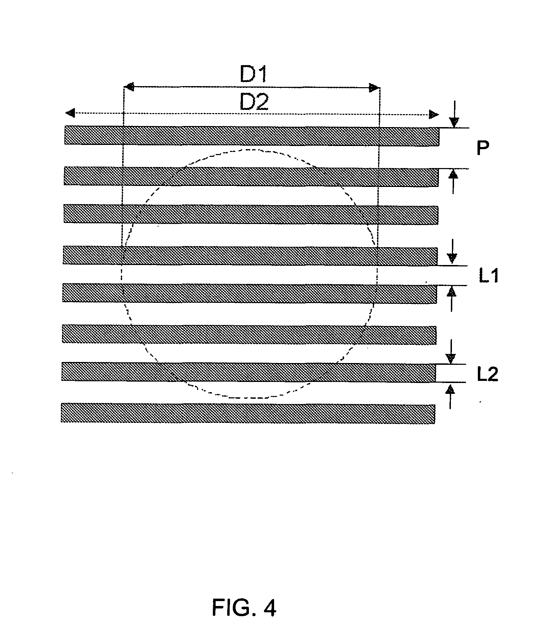

Die Herstellung und die Form einer bevorzugten Ausgestaltung der periodischen Struktur 80 wird nachfolgend unter Bezugnahme auf die Figuren 3 und 4 näher erläutert. Dabei ist der Herstellungsprozess der periodischen Gitterstruktur in Figur 3 schematisch zeitlich von oben nach unten dargestellt. Figur 4 zeigt eine senkrechte Aufsicht auf die Gitterebene.

Auf der freiliegenden Halbleiterschicht 70 wird zunächst eine Lackschicht 300 aufgebracht und die zu erzeugende Struktur in diese übertragen. Dazu eignen sich bekannte Nanostrukturtechniken wie Elektronenstrahllithografie, Nanoimprint oder Holographie. Nach der Entwicklung des Lacks wird die vordefinierte Struktur erhalten.

Anschließend wird durch ein Ätzverfahren die vordefinierte Struktur in die Halbleiterschicht 70 übertragen und die Lackschicht 300 danach entfernt. Im Beispiel wird eine beugungsgitterartige periodische Struktur mit einer Periodenlänge P und einem Tastverhältnis von 1:1 erhalten, so dass die Stegbreiten L2 den Grubenbreiten L1 entsprechen. Die Ätztiefe H wird so gewählt, dass sich eine stabile Vorzugsrichtung der Polarisation ergibt. Im vorliegenden Beispiel entspricht die Ätztiefe ca. 0,5 P.

Im dargestellten Beispiel beträgt die Periode P der Struktur λ/n, wobei λ die Emissionswellenlänge des Lasers und n die größere der beiden beteiligten Brechzahlen ist. Bei einer Emissionswellenlänge λ = 1310 nm und einer InP-Brechzahl n = 3,2 ergibt dies eine Periodenlänge von höchstens ∼400 nm. Somit betragen die Stegbreiten L2, die Grubenbreiten L1 sowie die Ätztiefe H jeweils ca. 200nm.

Nach dem Ätzvorgang wird die Lackmaske 300 entfernt und die freiliegende Struktur mit einer dielektrischen Schicht 90a bedeckt, die gleichzeitig die erste Schicht eines dielektrischen Braggspiegels 90 z.B. aus ZnS/CaF₂ oder *a-*Si/CaF₂ darstellt. Die laterale Ausdehnung D2 des Gitters 80 sollte mindestens der Ausdehnung D1 des vergrabenen Tunnelkontaktes 60 entsprechen.

Es versteht sich, dass in den dargestellten Figuren nur besonders bevorzugte Ausführungsformen der Erfindung dargestellt sind. Daneben ist jede andere Ausführungsform, insbesondere durch eine andere Anordnung oder einen anderen Aufbau der Schichten usw. denkbar, ohne den Rahmen dieser Erfindung zu verlassen. Die erfindungsgemäße Struktur kann auf (BTJ-)VCSEL in verschiedenen Materialsystemen angewendet werden. Hierzu zählen u.a. GaAs-, InP- oder GaSb-basierte Bauelemente.

## Patentansprüche

1. Oberflächenemittierende Halbleiterlaserdiode aufweisend einen Resonator mit einer ersten Bragg-Reflektorschichtenfolge (20), einer einen pn-Übergang aufweisenden aktiven Zone (40), die in eine Halbleiterschichtenfolge (30, 50, 60,70) eingebettet ist, und einer zweiten Bragg-Reflektorschichtenfolge (90), wobei die Halbleiterlaserdiode (100; 200) eine Emissionswellenlänge λ aufweist,
**gekennzeichnet durch**
eine innerhalb des Resonators angeordnete, als Subwellenlängengitter ausgebildete periodische Struktur (80) aus halbleitendem Material (70) und dielektrischem Material (90a), deren Haupterstreckungsebene im wesentlichen senkrecht zur Abstrahlrichtung (A) der Halbleiterlaserdiode (100; 200) angeordnet ist und die sich in unmittelbarem Kontakt zu mindestens einer der die aktive Zone (40) einbettenden Halbleiterschichten (30, 70) und zu mindestens einer der beiden Bragg-Reflektorschichtfolgen (20, 90) befindet.

2. Halbleiterlaserdiode nach Anspruch 1, wobei die periodische Struktur aus mindestens einem Material der Halbleiterschichten (30, 70) und mindestens einem Material einer der beiden Bragg-Reflektorschichtenfolgen (20, 90) besteht.

3. Halbleiterlaserdiode nach Anspruch 1 oder 2, bei der die Periode (P) der periodischen Struktur (80) höchstens λ/2 beträgt.

4. Halbleiterlaserdiode nach Anspruch 1, 2 oder 3, bei der die Periode (P) der periodischen Struktur (80) höchstens λ/n, vorzugsweise höchstens λ/2n, beträgt, wobei n eine Funktion der Brechzahl des halbleitenden Materials (70) und/oder der Brechzahl des dielektrischen Materials (90a) ist.

5. Halbleiterlaserdiode nach Anspruch 4, bei der n die größere der beiden Brechzahlen ist.

6. Halbleiterlaserdiode nach einem der vorstehenden Ansprüche, bei der die periodische Struktur (80) unmittelbar an die zweite Bragg-Reflektorschichtenfolge (90) grenzt.

7. Halbleiterlaserdiode nach Anspruch 6, bei der ein Material der periodischen Struktur (80), insbesondere das dielektrische Material, gleich dem Material der angrenzenden Schicht (90a) der zweiten Bragg-Reflektorschichtenfolge (90) ist.

8. Halbleiterlaserdiode nach einem der vorstehenden Ansprüche, bei der die zweite Bragg-Reflektorschichtenfolge (90) ein Wechselschichtsystem bestehend aus mindestens zwei brechzahldifferenten Materialien darstellt.

9. Halbleiterlaserdiode nach einem der vorstehenden Ansprüche, bei der der Resonator weiterhin eine Tunnelkontaktschicht (60) auf der p-Seite der aktiven Zone (40) aufweist.

10. Halbleiterlaserdiode nach Anspruch 9, bei der eine Abmessung (D2) oder die Fläche der Projektion der periodischen Struktur (80) auf die Tunnelkontaktschicht (60) zumindest einer Abmessung (D2) bzw. der Fläche einer Apertur der Tunnelkontaktschicht (60) entspricht.

11. Halbleiterlaserdiode nach Anspruch 9 oder 10, bei der die Tunnelkontaktschicht (60) an eine n-dotierte Halbleiterschicht (70) grenzt.

12. Halbleiterlaserdiode nach Anspruch 11, bei der die periodische Struktur (80) unmittelbar an die n-dotierte Halbleiterschicht (70) grenzt.

13. Halbleiterlaserdiode nach Anspruch 12, bei der das halbleitende Material der periodischen Struktur (80) gleich dem Material der angrenzenden n-dotierten Halbleiterschicht (70) ist.

14. Verfahren zur Herstellung einer Halbleiterlaserdiode (100; 200) mit folgenden Schritten:
Aufbringen eines Resonators umfassend zumindest eine erste Bragg-Reflektorschichtenfolge (20), eine einen pn-Übergang aufweisenden aktiven Zone (40), die in eine Halbleiterschichtenfolge (30, 50, 60,70) eingebettet ist, und eine zweite Bragg-Reflektorschichtenfolge (90) auf ein Substrat (10),
Aufbringen eines Subwellenlängengitters (80) als periodische Struktur (80) aus halbleitendem (70) und dielektrischem (90a) Material, dessen Haupterstreckungsebene im wesentlichen senkrecht zur Abstrahlrichtung (A) der Halbleiterlaserdiode (100; 200) angeordnet ist, innerhalb des Resonators in unmittelbarem Kontakt zu mindestens einer der die aktive Zone (40) einbettenden Halbleiterschichten (30, 70) und zu mindestens einer der beiden Bragg-Reflektorschichtfolgen (20, 90).

15. Verfahren nach Anspruch 14 mit folgenden Schritten:
Aufbringen der als n-dotierter epitaktischer Bragg-Spiegel (20) ausgebildeten ersten Bragg-Reflektorschichtenfolge,
anschließendes Aufbringen einer n-dotierten Confinementschicht (30),
anschließendes Aufbringen der einen pn-Übergang aufweisenden aktiven Zone (40),
anschließendes Aufbringen einer p-dotierten Confinementschicht (50),
anschließendes Aufbringen einer Tunnelkontaktschicht (60),
anschließendes Strukturieren der Tunnelkontaktschicht (60), um eine Apertur zu erzeugen,
anschließendes Aufbringen einer Halbleiterschicht (70),
anschließendes Strukturieren der Halbleiterschicht (70), um die periodische Struktur (80) zu definieren,
anschließendes Aufbringen der zweiten Bragg-Reflektorschichtenfolge (90).

## Claims

1. Surface-emitting semiconductor laser diode comprising a resonator with a first Bragg reflector layer sequence (20), an active zone (40) comprising a pn transition, said zone (40) being embedded in a semiconductor layer sequence (30, 50, 60, 70), and with a second Bragg reflector layer sequence (90), the semiconductor laser diode (100; 200) having an emission wavelength λ,
**characterised by**
a periodic structure (80) of semiconducting material (70) and dielectric material (90a) arranged inside the resonator, embodied as a sub-wavelength grating, the main plane of extent of which is disposed substantially perpendicularly to the direction of radiation (A) of the semiconductor laser diode (100; 200) and which is in direct contact with at least one of the semiconductor layers (30, 70) embedding the active zone (40) and with at least one of the two Bragg reflector layer sequences (20, 90).

2. Semiconductor laser diode according to claim 1, wherein the periodic structure consists of at least one material of the semiconductor layers (30, 70) and at least one material of one of the two Bragg reflector layer sequences (20, 90).

3. Semiconductor laser diode according to claim 1 or 2, wherein the period (P) of the periodic structure (80) is at most λ/2.

4. Semiconductor laser diode according to claim 1, 2 or 3, wherein the period (P) of the periodic structure (80) is at most λ/n, preferably at most λ/2n, where n is a function of the refractive index of the semiconducting material (70) and/or of the refractive index of the dielectric material (90a).

5. Semiconductor laser diode according to claim 4, wherein n is the greater of the two refractive indices.

6. Semiconductor laser diode according to one of the preceding claims, wherein the periodic structure (80) is immediately adjacent to the second Bragg reflector layer sequence (90).

7. Semiconductor laser diode according to claim 6, wherein a material of the periodic structure (80), particularly the dielectric material, is identical to the material of the adjacent layer (90a) of the second Bragg reflector layer sequence (90).

8. Semiconductor laser diode according to one of the preceding claims, wherein the second Bragg reflector layer sequence (90) is an alternating layer system consisting of at least two materials with different refractive indices.

9. Semiconductor laser diode according to one of the preceding claims, wherein the resonator further comprises a tunnel contact layer (60) on the p side of the active zone (40).

10. Semiconductor laser diode according to claim 9, wherein a dimension (D2) or the area of the projection of the periodic structure (80) on the tunnel contact layer (60) corresponds at least to a dimension (D2) or the area of an aperture of the tunnel contact layer (60).

11. Semiconductor laser diode according to claim 9 or 10, wherein the tunnel contact layer (60) is adjacent to an n-doped semiconductor layer (70).

12. Semiconductor laser diode according to claim 11, wherein the periodic structure (80) is directly adjacent to the n-doped semiconductor layer (70).

13. Semiconductor laser diode according to claim 12, wherein the semiconductor material of the periodic structure (80) is identical to the material of the adjacent n-doped semiconductor layer (70).

14. Method of producing a semiconductor laser diode (100; 200) comprising the following steps:
applying a resonator comprising at least one first Bragg reflector layer sequence (20), an active zone (40) comprising a pn transition, said zone (40) being embedded in a semiconductor layer sequence (30, 50, 60, 70), and a second Bragg reflector layer sequence (90) to a substrate (10),
applying a sub-wavelength grating (80) as a periodic structure (80) of semiconducting (70) and dielectric material (90a), the main plane of extent of which is disposed substantially perpendicularly to the direction of radiation (A) of the semiconductor laser diode (100; 200), within the resonator in direct contact with at least one of the semiconductor layers (30, 70) embedding the active zone (40), and with at least one of the two Bragg reflector layer sequences (20, 90).

15. Method according to claim 15 comprising the following steps:
applying the first Bragg reflector layer sequence embodied as an n-doped epitaxial Bragg mirror (20),
subsequently applying an n-doped confinement layer (30),
subsequently applying the active zone (40) comprising a pn transition,
subsequently applying a p-doped confinement layer (50),
subsequently applying a tunnel contact layer (60),
subsequently structuring the tunnel contact layer (60) in order to produce an aperture,
subsequently applying a semiconductor layer (70),
subsequently structuring the semiconductor layer (70) in order to define the periodic structure (80),
subsequently applying the second Bragg reflector layer sequence (90).

## Revendications

1. Diode laser à semi-conducteur à émission par la surface comportant un résonateur ayant une première séquence de couche de réflecteur de Bragg (20), une zone active (40) comportant une transition pn, ladite zone (40) étant intégrés dans une séquence de couche à semi-conducteur (30, 50, 60, 70), et ayant une seconde séquence de couche de réflecteur de Bragg (90), la diode laser à semi-conducteur (100 ; 200) ayant une longueur d'onde d'émission λ, **caractérisée par**
une structure périodique (80) de matériau semi-conducteur (70) et de matériau diélectrique (90a), agencée à l'intérieur du résonateur, mise en oeuvre sous forme d'un réseau de sous-longueurs d'onde, le plan principal d'extension de celui-ci étant disposé sensiblement perpendiculairement à la direction de rayonnement (A) de la diode laser à semi-conducteur (100 ; 200) et lequel est en contact direct avec au moins l'une des couches à semi-conducteur (30, 70) intégrant la zone active (40) et ayant au moins l'une des deux séquences de couche de réflecteur de Bragg (20, 90).

2. Diode laser à semi-conducteur selon la revendication 1, dans laquelle la structure périodique est constituée d'au moins un matériau des couches à semi-conducteur (30, 70) et d'au moins un matériau de l'une des deux séquences de couche de réflecteur de Bragg (20, 90).

3. Diode laser à semi-conducteur selon la revendication 1 ou 2, dans laquelle la période (P) de la structure périodique (80) est d'au moins λ/2.

4. Diode laser à semi-conducteur selon la revendication 1, 2 ou 3, dans laquelle la période (P) de la structure périodique (80) est d'au moins λ/n, de manière préférée d'au moins λ/2n, où n est une fonction de l'indice de réfraction du matériau semi-conducteur (70) et/ou de l'indice de réfraction du matériau diélectrique (90a).

5. Diode laser à semi-conducteur selon la revendication 4, dans laquelle n est le plus élevé des deux indices de réfraction.

6. Diode laser à semi-conducteur selon l'une des revendications précédentes, dans laquelle la structure périodique (80) est immédiatement adjacente à la seconde séquence de couche de réflecteur de Bragg (90).

7. Diode laser à semi-conducteur selon la revendication 6, dans laquelle un matériau de la structure périodique (80), particulièrement le matériau diélectrique, est identique au matériau de la couche adjacente (90a) de la seconde séquence de couche de réflecteur de bragg (90).

8. Diode laser à semi-conducteur selon l'une des revendications précédentes, dans laquelle la seconde séquence de couche de réflecteur de Bragg (90) est un système de couches qui alternent constitué d'au moins deux matériaux ayant des indices de réfraction différents.

9. Diode laser à semi-conducteur selon l'une des revendications précédentes, dans laquelle le résonateur comporte en outre une couche de contact de type tunnel (60) sur le côté p de la zone active (40).

10. Diode laser à semi-conducteur selon la revendication 9, dans laquelle une dimension (D2) ou la zone de la projection de la structure périodique (80) sur la couche de contact de type tunnel (60) correspond au moins à une dimension (D2) ou à la zone d'une ouverture de la couche de contact de type tunnel (60).

11. Diode laser à semi-conducteur selon la revendication 9 ou 10, dans laquelle la couche de contact de type tunnel (60) est adjacente à une couche à semi-conducteur dopée n (70).

12. Diode laser à semi-conducteur selon la revendication 11, dans laquelle la structure périodique (80) est directement adjacente à la couche à semi-conducteur dopée n (70).

13. Diode laser à semi-conducteur selon la revendication 12, dans laquelle le matériau semi-conducteur de la structure périodique (80) est identique au matériau de la couche à semi-conducteur dopée n (70) adjacente.

14. Procédé destiné à produire une diode laser à semi-conducteur (100 ; 200) comportant les étapes suivantes consistant à :
appliquer un résonateur comportant au moins une première séquence de couche de réflecteur de Bragg (20), une zone active (40) comportant une transition pn, ladite zone (40) étant intégrée dans une séquence de couche à semi-conducteur (30, 50, 60, 70), et une seconde séquence de couche de réflecteur de Bragg (90) à un substrat (10),
appliquer un réseau de sous-longueurs d'onde (80) en tant que structure périodique (80) de couche à semi-conducteur (70) et de matériau diélectrique (90a), le plan principal d'extension de celui-ci étant disposé sensiblement perpendiculairement à la direction de rayonnement (A) de la diode laser à semi-conducteur (100 ; 200), dans le résonateur en contact direct avec au moins l'une des couches à semi-conducteur (30, 70) intégrant la zone active (40), et ayant au moins l'une des deux séquences de couche de réflecteur de Bragg (20, 90).

15. Procédé selon la revendication 15 comportant les étapes suivantes consistant à :
appliquer la première séquence de couche de réflecteur de Bragg mise en oeuvre sous forme d'un miroir de Bragg épitaxial dopé n (20),
appliquer par la suite une couche de confinement dopée n (30),
appliquer par la suite la zone active (40) comportant une transition pn,
appliquer par la suite une couche de confinement dopée p (50),
appliquer par la suite une couche de contact de type tunnel (60),
structurer par la suite la couche de contact de type tunnel (60) afin de produire une ouverture,
appliquer par la suite une couche à semi-conducteur (70),
structurer par la suite la couche à semi-conducteur (70) afin de définir la structure périodique (80),
appliquer par la suite la seconde séquence de couche de réflecteur de Bragg (90).
